# EUROPÄISCHE PATENTSCHRIFT

(11) **EP 1 330 876 B1**
(45) Veröffentlichungstag und Bekanntmachung des Hinweises auf die Patenterteilung: **14.04.2004**
(21) Anmeldenummer: 01982393.9
(22) Anmeldetag: 04.10.2001
(51) Int. Cl.: H03K 19/003, G05B 9/03

(54) **ELEKTRONISCHES SICHERHEITSSCHALTGERÄT**
ELECTRONIC SAFETY SWITCHING DEVICE
APPAREIL DE COMMUTATION DE SECURITE ELECTRONIQUE

(30) Priorität: 30.10.2000 DE 10053820
(43) Veröffentlichungstag der Anmeldung: 30.07.2003
(73) Patentinhaber: PILZ GmbH & CO., 73760 Ostfildern (DE)
(72) Erfinder: RUPP, Roland, 73110 Hattenhofen (DE); SCHWENKEL, Hans, 70192 Stuttgart (DE)
(74) Vertreter: Duhme, Torsten
(86) Internationale Anmeldenummer: PCT/EP2001/011436
(87) Internationale Veröffentlichungsnummer: WO 2002/037680

(56) Entgegenhaltungen:
- DE-A- 4 122 016
- DE-A- 19 716 197

## Beschreibung

Die vorliegende Erfindung betrifft die Verwendung eines elektronischen Sicherheitsschaltgerätes zum Durchführen von fehlersicheren Abschaltvorgängen an Maschinen und Anlagen im industriellen Bereich.

Ein aufgrund seiner Verwendung bekanntes Sicherheitsschaltgerät für derartige Anwendungen besitzt einen ersten und einen zweiten Signalverarbeitungskanal, denen zur Signalverarbeitung Eingangssignale zuführbar sind und die verarbeitete Ausgangssignale bereitstellen, wobei der erste und der zweite Signalverarbeitungskanal die zugeführten Eingangssignale redundant zueinander verarbeiten, und wobei der erste und der zweite Signalverarbeitungskanal jeweils mit Hilfe integrierter Halbleiterstrukturen aufgebaut sind. Beispielhaft hierzu sei auf die Sicherheitsschaltgeräte der Typenbezeichnung PNOZ verwiesen, die von der Anmelderin der vorliegenden Erfindung bereits seit langem vertrieben werden.

Sicherheitsschaltgeräte der eingangs genannten Art werden im industriellen Bereich eingesetzt, um Abschaltvorgänge an Maschinen und Anlagen auf fehlersichere Art und Weise durchzuführen. "Fehlersicher" bedeutet dabei in diesem Zusammenhang, daß das Schaltgerät zumindest die Sicherheitskategorie 3 der Europäischen Norm EN 954-1 erfüllt. Beispielsweise werden derartige Geräte verwendet, um in Reaktion auf die Betätigung eines Not-Aus-Tasters oder das Öffnen einer Schutztür eine Maschinenanlage, wie beispielsweise eine Presse oder einen selbständig arbeitenden Roboter, stillzusetzen oder anderweitig in einen gefahrlosen Zustand zu überführen. Auch zum Durchführen von Wartungs- oder Instandsetzungsarbeiten ist es in der Regel notwendig, eine Maschine oder Maschinenanlage zumindest teilweise fehlersicher stromlos zu schalten. Da eine Fehlfunktion oder ein Versagen des Sicherheitsschaltgerätes in einer solchen Situation eine unmittelbare Gefahr für Menschen zur Folge hat, werden hinsichtlich der Fehlersicherheit von Sicherheitsschaltgeräten sehr hohe Anforderungen gestellt. In der Regel dürfen Sicherheitsschaltgeräte daher erst nach einer entsprechenden Zulassung durch eine zuständige Aufsichtsbehörde, beispielsweise die Berufgenossenschaften oder den TÜV, im industriellen Bereich verwendet werden.

Eine an sich bekannte Maßnahme zum Erreichen der erforderlichen Fehlersicherheit ist es, das Sicherheitsschaltgerät mehrkanalig-redundant aufzubauen, wobei sich die zumindest zwei Signalverarbeitungskanäle gegenseitig überwachen. Tritt in einem der Signalverarbeitungskanäle ein Fehler auf, muß der zweite Signalverarbeitungskanal in der Lage sein, diesen zu erkennen und einen für Personen im Bereich der Maschinenanlage gefahrlosen Zustand herbeizuführen. Eine besondere Aufmerksamkeit muß bei diesem Vorgehen auf mögliche Fehlerursachen gelegt werden, die mehrere oder alle redundanten Signalverarbeitungskanäle in gleicher weise beeinflussen, da ansonsten die erforderliche Fehlersicherheit nicht gewährleistet ist (sogenannte Common Cause Fehler).

Ein häufig praktiziertes Vorgehen bei der Zulassung von Sicherheitsschaltgeräten durch die zuständigen Aufsichtsbehörden ist es, daß der Konstrukteur oder Hersteller des Sicherheitsschaltgerätes eine eingehende und detaillierte Fehlerbetrachtung vorlegen muß, in der jeder denkbare Fehler erfaßt ist. Darin muß bewiesen werden, daß das Sicherheitsschaltgerät auch bei Auftreten des jeweiligen Fehlers in zuverlässiger Weise einen gefahrlosen Zustand für Personen herbeiführen kann. Eine derartige Betrachtung ist insbesondere bei komplexen Sicherheitsschaltgeräten mit zahlreichen Funktionen sehr aufwendig, was sich nachteilig auf die Kosten der Entwicklung und Herstellung auswirkt. Hinzu kommt, daß diese Fehlerbetrachtung auch bei geringen Änderungen am Aufbau oder in der Struktur des Sicherheitsschaltgeräts wiederholt werden muß, da beispielsweise allein durch eine räumlich unterschiedliche Anordnung von an sich gleichen Bauelementen neue Fehlerquellen erzeugt werden können.

Aus DE 197 16 197 A1 ist ein Mikroprozessorsystem für sicherheitskritische Regelungen bekannt, bei dem mindestens drei Zentraleinheiten gemeinsam auf einem Clip angeordnet sind und das gleiche Programm abarbeiten. Dieses bekannte Mikroprozessorsystem wird für Anwendungen auf dem Gebiet der Kraftfahrzeugtechnik, nämlich für Antiblockiersysteme, Antriebsschlupfregelungssysteme, Fahrstabilitätsregelungen, Fahrwerksregelungssysteme, etc. vorgeschlagen. Ein Bezug zu Problemstellungen auf dem Gebiet der Steuerung von Maschinen für industrielle Anwendungszwecke ist nicht erkennbar.

Gleiches gilt für die DE 41 22 016 A1, aus der ein Antiblockierregelsystem bekannt ist, bei dem zwei Mikrocontroller zur Anwendung kommen. In einer Zusammenfassung dieser Druckschrift in der elektronischen Datenbank WPI der Firma Derwent Publications Ltd., findet sich der Hinweis, dass die Mikrocontroller auf dem gleichen Chip angeordnet sein können.

Vor diesem Hintergrund ist es eine Aufgabe der vorliegenden Erfindung, ein Sicherheitsschaltgerät der eingangs genannten Art, das heißt also ein Sicherheitsschaltgerät zum Durchführen von Abschaltvorgängen an Maschinen und Anlagen im industriellen Bereich, anzugeben, bei dem der Aufwand zum Nachweis der Fehlersicherheit reduziert ist.

Diese Aufgabe wird durch die Verwendung eines Sicherheitsschaltgeräts der eingangs genannten Art gelöst, bei dem der erste und der zweite Signalverarbeitungskanal monolithisch auf einem gemeinsamen Halbleitersubstrat angeordnet sind, wobei die Halbleiterstrukturen jedes Signalverarbeitungskanals räumlich um ein Vielfaches ihrer Breite von den Halbleiterstrukturen jedes anderen Signalverarbeitungskanals beabstandet sind.

Erfindungsgemäß wird also die Verwendung eines Sicherheitsschaltgerätes zum Durchführen von fehlersicheren Abschaltvorgängen an Maschinen und Anlagen im industriellen Bereich vorgeschlagen, bei dem die zueinander redundanten Signalverarbeitungskanäle erstmals gemeinsam in einem Halbleiterchip angeordnet sind. Dabei ist nicht ausgeschlossen, daß jeder der Signalverarbeitungskanäle in Abhängigkeit von der Art und der Funktionalität des Sicherheitsschaltgeräts zusätzlich noch mit Hilfe von externen Bauelementen, beispielsweise zum Einstellen von Zeitkonstanten, ergänzt wird. Die Vorteile der Erfindung wirken sich jedoch um so stärker aus, je weniger zusätzliche externe Bauelemente benötigt werden. Bevorzugt erfolgt die neue Verwendung, um in Reaktion auf die Betätigung eines Not-Aus-Tasters oder das Öffnen einer Schutztür eine Maschinenanlage, insbesondere eine Presse oder einen selbständig arbeitenden Roboter, stillzusetzen oder zumindest teilweise fehlersicher stromlos zu schalten.

Durch die gemeinsame Anordnung der redundanten Signalverarbeitungskanäle läßt sich die gesamte Struktur des Sicherheitsschaltgerätes in einer später nicht mehr veränderbaren Form bei der Konstruktion und Entwicklung des Halbleiterchips festlegen. Infolgedessen muß die für die Zulassung durch die Aufsichtsbehörden erforderliche Fehlerbetrachtung nur einmalig durchgeführt werden, nämlich bei der Entwicklung des Halbleiterchips. Spätere Überprüfungen können sich darauf beschränken, die Einhaltung der bei der Entwicklung des Halbleiterchips festgelegten Spezifikationen, insbesondere die Einhaltung von vorgesehenen räumlichen Abmessungen und verwendeten Materialien, quantitativ zu überprüfen. Derartige Überprüfungen können wesentlich einfacher durchgeführt werden als die aufwendigen Fehlerbetrachtungen.

Darüber hinaus besitzt die erfindungsgemäße Maßnahme den Vorteil, daß aufgrund der Unveränderlichkeit des Halbleiterchips nach seiner Herstellung bestimmte Fehlerursachen von vornherein zuverlässig ausgeschlossen werden können. So kann bei einer Fehlerbetrachtung beispielsweise ein Kurzschluß zwischen zwei Leiterbahnen auf dem Halbleitersubstrat ausgeschlossen werden, wenn die beiden Leiterbahnen einen ausreichenden Abstand voneinander einhalten. Im Gegensatz dazu könnte beispielsweise zwischen zwei Leiterkabeln, die in an sich bekannter Weise voneinander isoliert sind, im Betrieb ein Kurzschluß durch eine mechanische Quetschung entstehen.

Die erfindungsgemäße Maßnahme besitzt des weiteren den Vorteil, daß die anerkannten und bewährten Methoden zur Durchführung der Fehlerbetrachtung in gleicher Weise wie bisher angewendet werden können, was nicht zuletzt auch die Akzeptanz bei den zuständigen Aufsichtsbehörden erleichtert. Aufgrund der Unveränderlichkeit des Halbleiterchips lassen sich dabei insbesondere diejenigen Methoden übertragen, die bei der Fehlerbetrachtung von Leiterplatten anerkannt sind.

Des weiteren besitzt die erfindungsgemäße Maßnahme den Vorteil, daß ein Halbleiterchip in an sich bekannter Weise und mit bewährten Herstellungsverfahren in ein staubdichtes Gehäuse eingebracht werden kann, was Fehlerursachen infolge industrieller Verschmutzung wesentlich minimiert. Derartige Fehlerursachen können daher bei der durchzuführenden Fehlerbetrachtung ebenfalls ausgeschlossen werden.

Darüber hinaus kann das erfindungsgemäße Sicherheitsschaltgerät in sehr großen Stückzahlen sehr rationell gefertigt werden, ohne daß hierdurch zusätzliche Fehlerursachen geschaffen werden. Nicht zuletzt läßt sich das erfindungsgemäße Sicherheitsschaltgerät aufgrund der vorgeschlagenen Maßnahme sehr stark miniaturisieren, was die Verwendungsbreite und die Einsatzmöglichkeiten erheblich vergrößert.

In einer Ausgestaltung der Erfindung weisen der erste und der zweite Signalverarbeitungskanal jeweils zumindest eine Kommunikationsschnittstelle zum gegenseitigen internen Datenaustausch auf.

Alternativ hierzu wäre es auch möglich, die redundanten Signalverarbeitungskanäle extern, d.h. außerhalb des Halbleitersubstrates, zum gegenseitigen Datenaustausch miteinander zu verbinden. Demgegenüber besitzt die bevorzugte Maßnahme den Vorteil, daß die Fehlerbetrachtung zum gegenseitigen Datenaustausch ebenfalls nur einmalig bei der Entwicklung des Halbleiterchips durchgeführt werden muß. Darüber hinaus ist der interne Datenaustausch schneller und freier von störenden Umwelteinflüssen möglich. Schließlich sind Fehlerursachen bei der Installation des erfindungsgemäßen Sicherheitsschaltgerätes reduziert.

In einer weiteren Ausgestaltung sind die Kommunikationsschnittstellen des ersten und zweiten Signalverarbeitungskanals über zumindest zwei räumlich getrennte Verbindungsleitungen miteinander verbunden.

Diese Maßnahme besitzt den Vorteil, daß auch die interne Kommunikation in einer mehrkanalig-redundanten Weise durchgeführt werden kann, wodurch die Fehlersicherheit des erfindungsgemäßen Sicherheitsschaltgerätes nochmals erhöht ist.

In einer weiteren Ausgestaltung der zuvor genannten Maßnahme sind die Verbindungsleitungen räumlich um ein Vielfaches ihrer Breite voneinander beabstandet.

Aufgrund dieser Maßnahme können Kurzschlüsse zwischen den Verbindungsleitungen und damit verbundene Fehlerursachen zuverlässig ausgeschlossen werden.

In einer weiteren Ausgestaltung der zuvor genannten Maßnahmen sind die Verbindungsleitungen rückwirkungsfrei ausgebildet.

Bevorzugt wird eine Rückwirkungsfreiheit dadurch erreicht, daß jede Verbindungsleitung eine rückwirkungsfreie Treiberstufe beinhaltet. Aufgrund dieser Maßnahme wird eine besonders gute Entkopplung der redundanten Signalverarbeitungskanäle erreicht, wodurch die Gefahr eines Totalausfalls des erfindungsgemäßen Sieherheitsschaltgerätes nochmals erheblich reduziert ist.

In einer weiteren Ausgestaltung weist jeder der Signalverarbeitungskanäle eigene Versorgungsanschlüsse auf, die von den Versorgungsanschlüssen der anderen Signalverarbeitungskanäle räumlich getrennt sind.

Mit dieser Maßnahme werden die einzelnen Signalverarbeitungskanäle noch unabhängiger voneinander, wodurch die Gefahr von Fehlern, die mehrere Signalverarbeitungskanäle in gleicher Weise betreffen, noch weiter reduziert ist. Die Fehlersicherheit des erfindungsgemäßen Sicherheitsschaltgeräts ist zuverlässiger noch besser gewährleistet.

In einer weiteren Ausgestaltung bilden die Halbleiterstrukturen jedes Signalverarbeitungskanals eine räumliche Gruppe, die als Ganzes von jeder räumlichen Gruppe jedes anderen Signalverarbeitungskanals beabstandet ist.

In dieser Ausgestaltung nehmen die redundanten Signalverarbeitungskanäle auf dem Halbleitersubstrat jeweils einen eigenen räumlichen Bereich ein. Zwischen den räumlichen Bereichen lassen sich gedanklich Trennlinien ziehen. Die Maßnahme besitzt den Vorteil, daß die einzelnen Signalverarbeitungskanäle räumlich optimal voneinander entkoppelt sind, was eine sehr große Unabhängigkeit ermöglicht. Zudem sind auch die Fehlerbetrachtung und die Entwicklung des Halbleiterchips spürbar vereinfacht.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

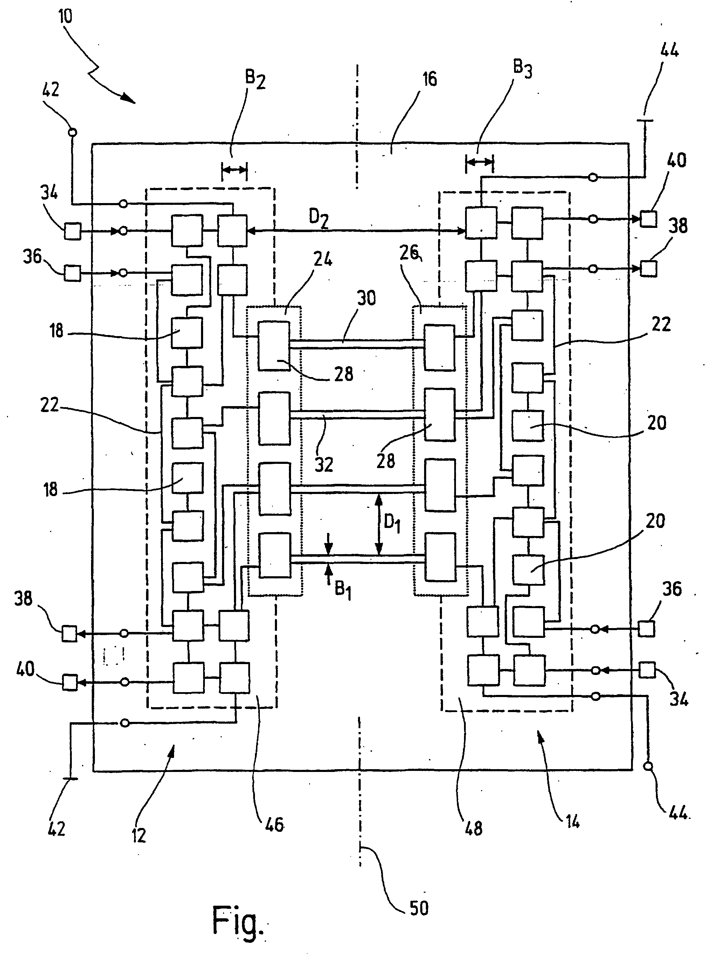

Ein Ausführungsbeispiel der Erfindung ist in der Zeichnung dargestellt und wird in der nachfolgenden Beschreibung näher erläutert.

In der einzigen Figur ist ein erfindungsgemäße Sicherheitsschaltgerät in seiner Gesamtheit mit der Bezugsziffer 10 bezeichnet.

Das Sicherheitsschaltgerät 10 besitzt in dem vorliegenden Ausführungsbeispiel einen ersten Signalverarbeitungskanal 12 und einen zweiten Signalverarbeitungskanal 14, die redundant zueinander ausgelegt sind. Die beiden Signalverarbeitungskanäle 12, 14 sind auf einem gemeinsamen Halbleitersubstrat 16 angeordnet. Das Sicherheitsschaltgerät 10 ist somit vollständig in einem Halbleiterchip realisiert. Der Halbleiterchip ist in an sich bekannter Weise (hier nicht dargestellt) in einem staubdichten Gehäuse eingegossen und somit vor Verschmutzung und anderen Umwelteinflüssen geschützt.

Jeder Signalverarbeitungskanal 12, 14 beinhaltet eine Vielzahl von Halbleiterstrukturen 18 bzw. 20, die auf dem Halbleitersubstrat 16 in an sich bekannter Weise durch Leiterbahnen 22 miteinander verbunden sind. Die Halbleiterstrukturen 18, 20 sind durch Dotieren hergestellte Strukturen in dem Halbleitersubstrat 16, die aufgrund ihrer räumlichen Anordnung Funktionsinseln bilden. Die Funktionsinseln bilden wiederum in an sich bekannter Weise elektronische Bauelemente, wie beispielsweise Transistoren, Dioden oder Kapazitäten. Durch die Zusammenschaltung dieser Bauelemente mit Hilfe der Leiterbahnen 22 entsteht eine elektronische Schaltung, die die einzelnen Signalverarbeitungskanäle 12, 14 bildet.

Mit den Bezugsziffern 24 bzw. 26 ist jeweils eine Kommunikationsschnittstelle bezeichnet, über die die beiden Signalverarbeitungskanäle 12, 14 gegenseitig einen internen Datenaustausch durchführen können. Die Kommunikationsschnittstellen 24, 26 beinhalten einzelne Treiberstufen 28, die eine rückwirkungsfreie Übertragung von Daten ermöglichen. Die Übertragung der Daten erfolgt über chipinterne Verbindungsleitungen 30, 32.

Wie in der Figur dargestellt, beträgt der räumliche Abstand D₁ zwischen zwei benachbarten, Verbindungsleitungen 30, 32 ein Vielfaches der Breite B₁ jeder Verbindungsleitung. Je nach Stärke der durch die Verbindungsleitungen 30, 32 fließenden Ströme beträgt der Abstand D₁ das 2-, 3-, 5-, oder sogar 10-fache der Breite B₁. Je größer der Abstand D₁ in Bezug auf die Breite B₁ der Verbindungsleitungen 30, 32 ist, desto sicherer kann ein Kurzschluß und/oder ein Übersprechen zwischen den Verbindungsleitungen 30, 32 ausgeschlossen werden.

Bevorzugt wird der Abstand D₁ daher um mehr als das 3-fache der Breite B₁ gewählt.

Mit den Bezugsziffern 34 bzw. 36 sind Eingangssignale bezeichnet, die den Signalverarbeitungskanälen 12, 14 über entsprechende Anschlüsse von außen zugeführt werden. Dabei erhalten die Signalverarbeitungskanäle 12, 14 die Eingangssignale 34, 36 hier über getrennte Anschlüsse, was eine große Unabhängigkeit der Signalverarbeitungskanäle 12, 14 gewährleistet. Alternativ hierzu ist es jedoch auch möglich, den Signalverarbeitungskanälen 12, 14 die Eingangssignale 34, 36 über einen gemeinsamen Anschluß zuzuführen.

Mit den Bezugsziffern 38, 40 sind Ausgangssignale bezeichnet, die von den Signalverarbeitungskanälen 12 bzw. 14 aufgrund der Signalverarbeitung bereitgestellt werden. Auch die Ausgangssignale 38, 40 sind im vorliegenden Ausführungsbeispiel über räumlich voneinander getrennte Anschlüsse zugänglich, was eine große Unabhängigkeit der Signalverarbeitungskanäle 12, 14 zur Folge hat. In entsprechender Weise besitzt auch jeder der Signalverarbeitungskanäle 12, 14 in dem hier gezeigten Ausführungsbeispiel eigene Versorungsanschlüsse 42 bzw. 44 für die Energieversorgung.

Die Eingangssignale 34, 36 stammen beispielsweise von zwei redundanten Kontakten eines Not-Aus-Tasters (hier nicht dargestellt). Die Ausgangssignale 38, 40 steuern redundante Kontakte von Relais (ebenfalls nicht dargestellt), mit denen eine Stromzuführung für eine überwachte Maschine unterbrochen wird.

Entsprechend der Erfindung sind die einzelnen Halbleiterstrukturen 18 des ersten Signalperarbeitungskarials 12 in einem Abstand D₂ von den Halbleiterstrukturen 20 des zweiten Signalverarbeitungskanals 14 angeordnet, wobei der Abstand D₂ ein Vielfaches der Breite B₂ jeder Halbleiterstruktur 18 beträgt. Ebenso ist der Abstand D₂ ein Vielfaches der Breite B₃ jeder Halbleiterstruktur 20 des zweiten Signalverarbeitungskanals 14. Dabei ist zu bemerken, daß die Halbleiterstrukturen 18, 20 in der vorliegenden Figur der Einfachheit halber in gleichen Abmessungen dargestellt sind, was in der Praxis jedoch nicht unbedingt erforderlich ist. Es versteht sich, daß der Abstand D₂ in diesem Fall dann jeweils ein Vielfaches der maximalen Breite der einzelnen Halbleiterstrukturen 18 bzw. 20 beträgt. Dabei gilt wiederum, daß die Fehlersicherheit und die Trennung der redundanten Signalverarbeitungskanäle 12, 14 um so zuverlässiger gewährleistet ist, je größer das Verhältnis des Abstandes D₂ zu der Breite der jeweiligen Halbleiterstrukturen 18, 20 ist.

Bei dem hier gezeigten Ausführungsbeispiel der Erfindung bilden die Halbleiterstrukturen 18 des ersten Signalverarbeitungskanals 12 eine räumliche Gruppe 46, die als Ganzes von der räumlichen Gruppe 48 der Halbleiterstrukturen 20 des zweiten Signalverarbeitungskanals 14 beabstandet ist. Auf diese Weise entsteht auf dem Halbleitersubstrat 16 eine klare räumliche Trennung zwischen den beiden Signalverarbeitungskanälen 12 und 14. Anschaulich gesprochen läßt sich hier eine klare Trennungslinie 50 zwischen den beiden Signalverarbeitungskanälen 12 bzw. 14 ziehen. In anderen Ausführungsbeispielen kann die Trennungslinie 50 auch eine kurvenförmige Kontur besitzen.

Es versteht sich, daß das erfindungsgemäße Sicherheitsschaltgerät in Abweichung von dem gezeigten Ausführungsbeispiel auch drei oder noch mehr redundante Signalverarbeitungskanäle 12, 14 aufweisen kann. In diesem Fall ist jeder der Signalverarbeitungskanäle in entsprechender Weise von jedem anderen beabstandet.

## Patentansprüche

1. Verwendung eines elektronischen Sicherheitsschaltgerätes zum Durchführen von fehlersicheren Abschaltvorgängen an Maschinen und Anlagen im industriellen Bereich, wobei das Sicherheitsschaltgerät zumindest einen ersten (12) und einen zweiten (14) Signalverarbeitungskanal aufweist, denen zur Signalverarbeitung Eingangssignale (34, 36) zugeführt werden und die verarbeitete Ausgangssignale (38, 40) bereitstellen, wobei der erste (12) und der zweite (14) Signalverarbeitungskanal die zugeführten Eingangssignale (34, 36) redundant zueinander verarbeiten, und wobei der erste (12) und der zweite (14) Signalverarbeitungskanal jeweils mit Hilfe integrierter Halbleiterstrukturen (18, 20) aufgebaut sind, **dadurch gekennzeichnet, daß** der erste (12) und der zweite (14) Signalverarbeitungskanal monolithisch auf einem gemeinsamen Halbleitersubstrat (16) angeordnet sind, wobei die Halbleiterstrukturen (18, 20) jedes Signalverarbeitungskanals (12, 14) räumlich um ein Vielfaches ihrer Breite (B₂, B₃) von den Halbleiterstrukturen (20, 18) jedes anderen Signalverarbeitungskanals (14, 12) beabstandet sind.

2. Verwendung eines elektronischen Sicherheitsschaltgerätes nach Anspruch 1, **dadurch gekennzeichnet, daß** der erste (12) und der zweite (14) Signalverarbeitungskanal jeweils zumindest eine Kommunikationsschnittstelle (24, 26) zum gegenseitigen internen Datenaustausch aufweisen.

3. Verwendung eines elektronischen Sicherheitsschaltgerätes nach Anspruch 2, **dadurch gekennzeichnet, daß** die Kommunikationsschnittstellen (24, 26) des ersten (12) und zweiten (14) Signalverarbeitungskanals über zumindest zwei räumlich getrennte Verbindungsleitungen (30, 32) miteinander verbunden sind.

4. Verwendung eines elektronischen Sicherheitsschaltgerätes nach Anspruch 3, **dadurch gekennzeichnet, daß** die Verbindungsleitungen (30, 32) räumlich um ein Vielfaches ihrer Breite (B₁) voneinander beabstandet sind.

5. Verwendung eines elektronischen Sicherheitsschaltgerätes nach Anspruch 3 oder 4, **dadurch gekennzeichnet, daß** die Verbindungsleitungen (30, 32) rückwirkungsfrei ausgebildet sind.

6. Verwendung eines elektronischen Sicherheitsschaltgerätes nach einem der Ansprüche 1 bis 5, **dadurch gekennzeichnet, daß** jeder der Signalverarbeitungskanäle (12, 14) eigene Versorgungsanschlüsse (42, 44) aufweist, die von den Versorgungsanschlüssen (44, 42) der anderen Signalverarbeitungskanäle (14, 12) räumlich getrennt sind.

7. Verwendung eines elektronischen Sicherheitsschaltgerätes nach einem der Ansprüche 1 bis 6, **dadurch gekennzeichnet,. daß** die Halbleiterstrukturen (18, 20) jedes Signalverarbeitungskanals (12, 14) eine räumliche Gruppe (46, 48) bilden, die als Ganzes von jeder räumlichen Gruppe (48, 46) jedes anderen Signalverarbeitungskanals (14, 12) beabstandet ist.

8. Verwendung eines elektronischen Sicherheitsschaltgerätes nach einem der Ansprüche 1 bis 7, um in Reaktion auf die Betätigung eines Not-Aus-Tasters oder das Öffnen einer Schutztür eine Maschinenanlage, insbesondere eine Presse oder einen selbständig arbeitenden Roboter, stillzusetzen oder zumindest teilweise fehlersicher stromlos zu schalten.

## Claims

1. The use of an electronic safety switching device for carrying out failsafe shutdown operations on machines and plants in the industrial sector, the safety switching device having at least a first (12) and a second (14) signal processing channel, to which input signals (34, 36) are supplied for signal processing and which provide processed output signals (38, 40), the first (12) and the second (14) signal processing channel processing the input signals (34, 36) supplied redundantly in relation to each other, and the first (12) and the second (14) signal processing channel each being constructed with the aid of integrated semiconductor structures (18, 20), **characterized in that** the first (12) and the second (14) signal processing channel are arranged monolithically on a common semiconductor substrate (16), the semiconductor structures (18, 20) of each signal processing channel (12, 14) being spaced apart physically by a multiple of their width (B₂, B₃) from the semiconductor structures (20, 18) of every other signal processing channel (14, 12).

2. The use of an electronic safety switching device of claim 1, **characterized in that** the first (12) and the second (14) signal processing channel each have at least one communication interface (24, 26) for mutual internal data interchange.

3. The use of an electronic safety switching device of claim 2, **characterized in that** the communication interfaces (24, 26) of the first (12) and second (14) signal processing channel are connected to each other via at least two physically separated connecting lines (30, 32).

4. The use of an electronic safety switching device of claim 3, **characterized in that** the connecting lines (30, 32) are spaced apart physically from one another by a multiple of their width (B₁).

5. The use of an electronic safety switching device of claim 3 or 4, **characterized in that** the connecting lines (30, 32) are designed to be feedback-free.

6. The use of an electronic safety switching device of any of claims 1 to 5, **characterized in that** each of the signal processing channels (12, 14) has its own power supply connections (42, 44), which are separated physically from the supply connections (44, 42) of the other signal processing channels (14, 12).

7. The use of an electronic switching device of any of claims 1 to 6, **characterized in that** the semiconductor structures (18, 20) of each signal processing channel (12, 14) form a physical group (46, 48) which, as a whole, is spaced apart from each physical group (48, 46) of each other signal processing channel (14, 12).

8. The use of an electronic safety switching device of any of claims 1 to 7 for stopping a machine plant, in particular a press or an independently operating robot, or for switching it off at least partly in a failsafe manner, as a reaction to actuation of an emergency off pushbutton or opening of a protective door.

## Revendications

1. Utilisation d'un commutateur électronique de sécurité permettant d'effectuer des opérations de mise hors circuit, avec tolérance de pannes, sur des machines et des installations dans le domaine industriel, le commutateur de sécurité présentant au moins un premier (12) et un deuxième (14) canal de traitement du signal auxquels sont envoyés des signaux d'entrée (34, 36) pour le traitement du signal, et qui fournissent des signaux de sortie (38, 40) traités, le premier (12) et le deuxième (14) canal de traitement du signal traitant les signaux d'entrée (34, 36) acheminés de manière redondante l'un par rapport à l'autre, et le premier (12) et le deuxième (14) canal de traitement du signal comportant des structures à semi-conducteurs (18, 20) intégrées, **caractérisé en ce que** le premier (12) et le deuxième (14) canal de traitement du signal sont montés de manière monolithique sur un substrat à semi-conducteurs (16) commun, les structures à semi-conducteurs (18, 20) de chaque canal de traitement du signal (12, 14) étant écartées, dans l'espace, selon un multiple de leur largeur (B₂, B₃), par rapport aux structures à semi-conducteurs (20, 18) de chaque autre canal de traitement du signal (14, 12).

2. Utilisation d'un commutateur électronique de sécurité selon la revendication 1, **caractérisée en ce que** le premier (12) et le deuxième (14) canal de traitement du signal présentent chacun au moins une interface de communication (24, 26) permettant un échange de données interne.

3. Utilisation d'un commutateur électronique de sécurité selon la revendication 2, **caractérisée en ce que** les interfaces de communication (24, 26) du premier (12) et du deuxième (14) canal de traitement du signal sont reliées par au moins deux lignes de connexion (30, 32) séparées dans l'espace.

4. Utilisation d'un commutateur électronique de sécurité selon la revendication 3, **caractérisée en ce que** les lignes de connexion (30, 32) sont écartées, dans l'espace, selon un multiple de leur largeur (B₁).

5. Utilisation d'un commutateur électronique de sécurité selon la revendication 3 ou 4, **caractérisée en ce que** les lignes de connexion (30, 32) sont exemptes de rétroaction.

6. Utilisation d'un commutateur électronique de sécurité selon l'une des revendications 1 à 5, **caractérisée en ce que** chacun des canaux de traitement du signal (12, 14) présente ses propres raccords d'alimentation (42, 44), qui sont séparés dans l'espace, des raccords d'alimentation (44, 42) de l'autre canal de traitement du signal (14, 12).

7. Utilisation d'un commutateur électronique de sécurité selon l'une des revendications 1 à 6, **caractérisée en ce que** les structures à semi-conducteurs (18, 20) de chaque canal de traitement du signal (12, 14) forment un groupe (46, 48), dans l'espace, qui, en tant qu'ensemble, est séparé de chaque groupe (48, 46), présent dans l'espace, de chaque autre canal de traitement du signal (14, 12).

8. Utilisation d'un commutateur électronique de sécurité selon l'une des revendications 1 à 7, pour, en réaction à l'actionnement d'un bouton d'arrêt d'urgence ou à l'ouverture d'une porte de sécurité, arrêter un équipement industriel, en particulier une presse ou un robot autonome, ou pour au moins le mettre partiellement hors circuit, avec tolérance de pannes.
